# DEMANDE DE BREVET EUROPEEN

(11) **EP 4 053 900 A1**
(43) Date de publication de la demande: **07.09.2022**
(21) Numéro de dépôt: 22156539.3
(22) Date de dépôt: 14.02.2022
(51) Int. Cl.: H01L 27/146, G01J 5/08, G01J 5/02, G01J 3/51, G01J 5/00, H01L 27/30, G01J 5/34

(54) **CAPTEUR HYBRIDE**

(30) Priorité: 05.03.2021 FR 2102161
(71) Demandeur: ISORG, 87068 Limoges Cedex 3 (FR)
(72) Inventeur: BOUTHINON, Benjamin, 38000 GRENOBLE (FR); GOMEZ, Jean-Yves, 38000 GRENOBLE (FR); DUPOIRON, Camille, 38000 GRENOBLE (FR)
(74) Mandataire: Cabinet Beaumont

(57) **Abrégé**

La présente description concerne un pixel (1) formé de plusieurs sous-pixels et comprenant :
au moins un détecteur pyroélectrique comprenant une première couche active (162) ; et
au moins un photodétecteur couleur organique comprenant une deuxième couche active (142),
chaque sous-pixel comprenant :
- une première électrode (146) et une deuxième électrode (80) qui sont, dans l'épaisseur, de part et d'autre de la deuxième couche active (142) et délimitent une photodiode ; et
- une troisième électrode (166) et une quatrième électrode (80) qui sont, dans l'empilement, de part et d'autre de la première couche active (162) et délimitent un détecteur.

## Description

### Domaine technique

La présente description concerne de façon générale un pixel de capteur d'images, pyroélectrique et piézoélectrique.

### Technique antérieure

Les capteurs d'images se multiplient dans des domaines variés grâce à leur miniaturisation. Selon les applications, un capteur d'images peut être adapté à faire l'acquisition d'un rayonnement électromagnétique visible ou infrarouge. Des capteurs infrarouges peuvent être directs c'est-à-dire qu'ils comprennent une couche active captant des photons dans l'infrarouge lointain ou indirects c'est-à-dire qu'ils comprennent une couche d'absorption infrarouge, chauffant lorsqu'elle capte des photons d'infrarouge lointain, associée à une couche pyroélectrique.

Le document US 2018/0240843 décrit un capteur d'empreintes à diodes électroluminescentes GaN.

Le document FR 3 093 377 décrit un capteur d'image couleur et infrarouge.

Le document US 2008/0283751 décrit des systèmes et procédés de transistors à effet de champ organiques.

Le document "Pyroelectric infrared detector based on polyaniline/polyvinylidene fluoride bled" de Sh. Ebrahim et al., SENSORS AND ACTUATORS A: PHYSICAL, ELSEVIER BV, NL, vol.238, 11 janvier 2016, pages 389-396 (XP029399656), décrit un détecteur pyroélectrique infrarouge.

### Résumé de l'invention

Pour certaines applications, il est souhaitable de disposer d'un capteur d'images permettant, au sein d'un même pixel, d'acquérir et de retranscrire des données optiques pyroélectriques.

Selon un premier aspect, un mode de réalisation prévoit un pixel comprenant au moins un photodétecteur couleur organique et au moins un détecteur pyroélectrique.

Selon un mode de réalisation, le ou les photodétecteurs couleur sont coplanaires au ou aux détecteurs pyroélectriques.

Selon un mode de réalisation, le ou les photodétecteurs couleur et le ou les détecteurs pyroélectriques recouvrent un substrat qui contient des circuits de lecture en technologie CMOS.

Selon un mode de réalisation, le ou les photodétecteurs couleur sont configurés pour absorber les ondes électromagnétiques du visible et d'une première partie du spectre infrarouge, dont la longueur d'onde est, de préférence comprise entre 700 nm et 1,7 µm et dans lequel le ou les détecteurs pyroélectriques sont configurés pour absorber le rayonnement électromagnétique d'une deuxième partie du spectre infrarouge dont la longueur d'onde est, de préférence comprise entre 1,7 µm et 1 mm.

Selon un mode de réalisation, le pixel comprend exactement deux photodétecteurs couleur monochromatiques et exactement deux détecteurs pyroélectriques.

Selon un mode de réalisation, le ou les détecteurs pyroélectriques comportent une couche d'absorption infrarouge.

Selon un mode de réalisation, la couche d'absorption infrarouge constitue une électrode du ou des détecteurs pyroélectriques.

Selon un mode de réalisation, la couche d'absorption infrarouge est en :
- dioxyde d'étain dopé en antimoine ;
- dioxyde d'étain ;
- Or ;
- PDOT:PSS ;
- nickel noir ;
- chrome ;
- or noir ; ou
- graphite.

Selon un mode de réalisation, chaque détecteurs pyroélectriques comprend une première couche active.

Selon un mode de réalisation, la première couche active est en polyfluorure de vinylidène ou en l'un de ses copolymères, le copolymère étant de préférence choisi dans la liste :
- copolymère de fluorure de vinylidène et de trifluoroéthylène ;
- copolymère de fluorure de vinylidène et de chlorure de trifluoroéthylène ;
- copolymère de fluorure de vinylidène et de hexafluoropropylène ; et
- un mélange d'au moins deux de ces copolymères.

Selon un mode de réalisation, la première couche active est en polyfluorure de vinylidène ou en l'un de ses terpolymères, le terpolymère est de préférence du terpolymère de fluorure de vinylidène et de trifluoroéthylène et de chlorofluoroéthylene.

Selon un mode de réalisation, la première couche active est en :
- polyfluorure de vinyle ;
- polychlorure de vinyle ;
- titanate de baryum ;
- titano-zirconate de plomb ;
- tantalate de lithium ;
- sulfate de triglycine ;
- titanate de plomb ;
- fluorure de vinylidène trifluoroéthylène ; ou
- un mélange d'au moins deux de ces composés.

Selon un mode de réalisation, la couche d'absorption infrarouge et la première couche active sont mélangées au sein d'une même couche.

Selon un mode de réalisation, la couche d'absorption infrarouge et la première couche active sont distinctes.

Selon un mode de réalisation, chaque photodétecteur couleur comprend une deuxième couche active.

Selon un mode de réalisation, la deuxième couche active est en un matériau organique.

Selon un mode de réalisation, une première électrode et une deuxième électrode sont dans l'épaisseur de part et d'autre de la deuxième couche active et délimitent deux photodétecteurs, une troisième électrode et une quatrième électrode sont dans l'épaisseur de part et d'autre de la première couche active et délimitent deux détecteurs pyroélectriques, la deuxième et la quatrième électrode étant de préférence communes entre les photodétecteurs couleur et les détecteurs pyroélectriques.

Selon un mode de réalisation, le pixel comprend quatre sous-pixels, un premier et un deuxième sous-pixel comprenant chacun un ou exactement quatre détecteurs pyroélectriques et un troisième et un quatrième sous-pixel comprenant chacun quatre photodétecteurs couleur, un rouge, un bleu et deux verts ordonnés selon la matrice de Bayer.

Selon un mode de réalisation, le pixel comprend une cinquième électrode et une sixième électrode sont, dans l'épaisseur, de part et d'autre de la première couche active contenue dans les premier et deuxième sous-pixels, la cinquième et la sixième électrode délimitent un autre détecteur pyroélectrique, une septième et une huitième électrode sont, dans l'épaisseur, de part et d'autre de la deuxième couche active de la partie de sous-pixel rouge des troisième et quatrième sous-pixels, la septième et la huitième électrode délimitent un autre photodétecteur couleur, une neuvième et une dixième électrode sont, dans l'épaisseur, de part et d'autre de la deuxième couche active de la partie de sous-pixel bleu des troisième et quatrième sous-pixels, la neuvième et la dixième électrode délimitent un autre photodétecteur couleur, une onzième et une douzième électrode sont, dans l'épaisseur, de part et d'autre de la deuxième couche active de la partie de sous-pixel vert des troisième et quatrième sous-pixel, la onzième et la douzième électrode délimitent un autre photodétecteur couleur, les sixième, huitième, dixième et douzième électrodes sont de préférence communes.

Selon un mode de réalisation, chaque photodétecteur couleur et chaque détecteur pyroélectrique sont séparés latéralement par un matériau, ce matériau étant de préférence un isolant thermique ou optique.

Un mode de réalisation prévoit un capteur d'images comprenant plusieurs pixels tels que décrits.

Selon un deuxième aspect, un mode de réalisation prévoit un pixel comprenant au moins un photodétecteur couleur organique et au moins un détecteur pyroélectrique.

Selon un mode de réalisation, le pixel est formé de plusieurs sous-pixels et comprenant :
au moins un détecteur pyroélectrique comprenant une première couche active ; et
au moins un photodétecteur couleur organique comprenant une deuxième couche active,
chaque sous-pixel comprenant :
   - une première électrode et une deuxième électrode qui sont, dans l'épaisseur, de part et d'autre de la deuxième couche active et délimitent une photodiode ; et
une troisième électrode et une quatrième électrode qui sont, dans l'empilement, de part et d'autre de la première couche active et délimitent un détecteur.

Selon un mode de réalisation, la deuxième et la quatrième électrode sont communes.

Selon un mode de réalisation, le pixel comprend exactement quatre photodétecteurs couleur, empilés avec un ou exactement quatre détecteurs pyroélectriques.

Selon un mode de réalisation, les photodétecteurs et le ou les détecteurs pyroélectriques recouvrent un substrat qui contient des circuits de lecture en technologie CMOS.

Selon un mode de réalisation, les photodétecteurs sont configurés pour absorber les ondes électromagnétiques du visible et d'une première partie du spectre infrarouge, dont la longueur d'onde est, de préférence comprise entre 700 nm et 1,7 µm et dans lequel le ou les détecteurs pyroélectriques sont configurés pour absorber le rayonnement électromagnétique d'une deuxième partie du spectre infrarouge dont la longueur d'onde est, de préférence comprise entre 1,7 µm et 1 mm.

Selon un mode de réalisation, les photodétecteurs et le ou les détecteurs pyroélectriques sont séparés par un diélectrique ayant la propriété de réflecteur thermique et/ou d'isolant thermique.

Selon un mode de réalisation, le ou les détecteurs pyroélectriques comportent une couche d'absorption infrarouge.

Selon un mode de réalisation, la couche d'absorption infrarouge constitue une électrode du ou des détecteurs pyroélectriques.

Selon un mode de réalisation, la couche d'absorption infrarouge est en :
- dioxyde d'étain dopé en antimoine ;
- dioxyde d'étain ;
- Or ;
- PDOT:PSS ;
- nickel noir ;
- or noir ;
- chrome ; ou
- graphite.

Selon un mode de réalisation, chaque détecteurs pyroélectriques comprend une première couche active.

Selon un mode de réalisation, la première couche active est en polyfluorure de vinylidène ou en l'un de ses copolymères, le copolymère étant de préférence choisi dans la liste :
- copolymère de fluorure de vinylidène et de trifluoroéthylène ;
- copolymère de fluorure de vinylidène et de chlorure de trifluoroéthylène ;
- copolymère de fluorure de vinylidène et de hexafluoropropylène ; et
- un mélange d'au moins deux de ces copolymères.

Selon un mode de réalisation, la première couche active est en polyfluorure de vinylidène ou en l'un de ses terpolymères, le terpolymère est de préférence du terpolymère de fluorure de vinylidène et de trifluoroéthylène et de chlorofluoroéthylene.

Selon un mode de réalisation, la première couche active est en :
- polyfluorure de vinyle ;
- polychlorure de vinyle ;
- titanate de baryum ;
- titano-zirconate de plomb ;
- tantalate de lithium ;
- sulfate de triglycine ;
- titanate de plomb ;
- fluorure de vinylidène trifluoroéthylène ; ou
- un mélange d'au moins deux de ces composés.

Selon un mode de réalisation, la couche d'absorption infrarouge et la première couche active sont mélangées au sein d'une même couche.

Selon un mode de réalisation, la couche d'absorption infrarouge et la première couche active sont distinctes.

Selon un mode de réalisation, chaque photodétecteur comprend une deuxième couche active.

Selon un mode de réalisation, la deuxième couche active est en un matériau organique.

Un mode de réalisation prévoit un sous-pixel dans un pixel tel que décrit, dans lequel :
- une première électrode et une deuxième électrode sont, dans l'épaisseur, de part et d'autre de la deuxième couche active et délimitent une photodiode ;
- une troisième électrode et une quatrième électrode sont, dans l'empilement, de part et d'autre de la première couche active et délimitent un détecteur,
   la deuxième et la quatrième électrode étant de préférence communes.

Selon un mode de réalisation, chaque électrode est reliée au substrat par au moins un via conducteur.

Un mode de réalisation prévoit un capteur d'images comprenant plusieurs pixels tels que décrits.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente une vue en perspective éclatée, partielle et schématique, d'un mode de réalisation d'un pixel de capteur d'images couleur et pyroélectrique selon un premier aspect ;
la figure 2 représente par des vues (A) et (B) en perspective éclatée, partielles et schématiques, deux modes de réalisations d'un pixel de capteur d'images ;
la figure 3 représente une vue en coupe, partielle et schématique, d'un mode de réalisation de deux pixels d'un capteur d'images tel que représenté en figure 2(A) ;
la figure 4 représente une vue en coupe, partielle et schématique, d'un autre mode de réalisation de deux pixels d'un capteur d'images tel que représenté en figure 2(A) ;
la figure 5 représente une vue en coupe, partielle et schématique, d'un autre mode de réalisation de deux pixels d'un capteur d'images tel que représenté en figure 2(A) ;
la figure 6 représente une vue en coupe, partielle et schématique, d'un autre mode de réalisation de deux pixels d'un capteur d'images tel que représenté en figure 2(A) ;
la figure 7 représente une vue en coupe, partielle et schématique, d'un autre mode de réalisation de deux pixels d'un capteur d'images tel que représenté en figure 2(A) ;
la figure 8 représente une vue en coupe, partielle et schématique, d'un autre mode de réalisation de deux pixels d'un capteur d'images tel que représenté en figure 2(A) ;
la figure 9 représente une vue en perspective éclatée, partielle et schématique, d'un autre mode de réalisation d'un pixel de capteur d'images couleur et pyroélectrique selon un deuxième aspect ;
la figure 10 représente par une vue en perspective éclatée, partielle et schématique, un mode de réalisation de quatre pixels de capteur d'images ;
la figure 11 représente une vue en coupe, partielle et schématique, d'un mode de réalisation de deux pixels d'un capteur d'images tel que représenté en figure 10 ;
la figure 12 représente une vue en coupe, partielle et schématique, d'un autre mode de réalisation de deux pixels d'un capteur d'images tel que représenté en figure 10 ;
la figure 13 représente une vue en coupe, partielle et schématique, d'un autre mode de réalisation de deux pixels d'un capteur d'images tel que représenté en figure 10 ;
la figure 14 représente une vue en coupe, partielle et schématique, d'un autre mode de réalisation de deux pixels d'un capteur d'images tel que représenté en figure 10 ;
la figure 15 représente par des vues (A) et (B) en perspective éclatée, partielles et schématiques, deux modes de réalisation d'un pixel de capteur d'images ; et
la figure 16 représente une vue en coupe, partielle et schématique, d'un autre mode de réalisation de d'un pixel d'un capteur d'images tel que représenté en figure 15.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

La transmittance d'une couche correspond au rapport entre l'intensité du rayonnement sortant de la couche et l'intensité du rayonnement entrant dans la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %. Dans la suite de la description, l'indice de réfraction d'un matériau correspond à l'indice de réfraction du matériau pour la plage de longueurs d'onde du rayonnement capté par le capteur d'images. Sauf indication contraire, l'indice de réfraction est considéré sensiblement constant sur la plage de longueurs d'onde du rayonnement utile, par exemple égal à la moyenne de l'indice de réfraction sur la plage de longueurs d'onde du rayonnement capté par le capteur d'images.

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche dont la longueur d'onde est comprise entre 700 nm et 1,7 µm et l'infrarouge lointain, dit également thermique dont la longueur d'onde est comprise entre 1,7 µm et 1 mm.

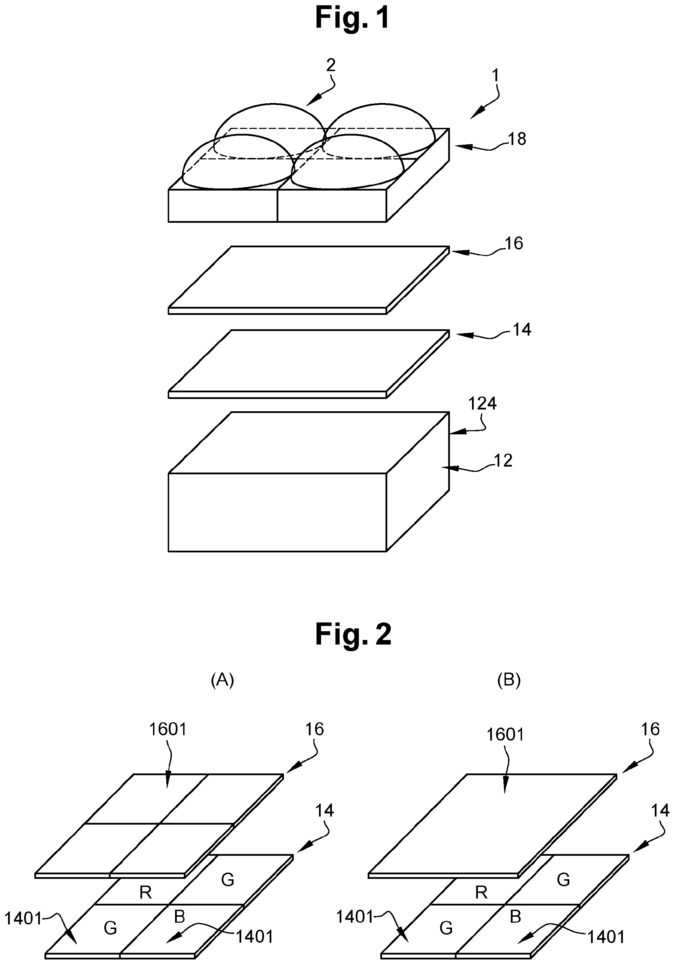

La figure 1 représente une vue en perspective éclatée, partielle et schématique, d'un mode de réalisation d'un pixel de capteur d'images couleur et pyroélectrique.

Le pixel 1 de capteur d'images comprend de bas en haut :
- un substrat 12 semi-conducteur ;
- des circuits de lecture 124 situés sur et dans le substrat 12 ;
- un premier élément 14 de premiers capteurs de photons, également appelés photodétecteurs, adaptés à capter une image couleur dans le visible et proche infrarouge ;
- un deuxième élément 16 d'un ou plusieurs deuxièmes capteurs, également appelés détecteurs, adaptés à capter une image dans l'infrarouge lointain ;
- des filtres couleur 18 ; et
- des microlentilles 2 recouvrant les filtres couleur.

Les éléments 14 et 16 sont associés à une matrice de circuits de lecture 124 réalisant la mesure des signaux captés par les éléments 14 et 16. Par circuit de lecture, on entend un ensemble de transistors de lecture, d'adressage et de commande du pixel ou sous-pixel défini par les éléments 14 et 16 correspondants.

L'élément 16 est, par exemple, un élément de détecteurs piézoélectriques et, plus particulièrement, pyroélectrique.

Dans le pixel 1 de capteur d'images, l'élément 16, appelé dans la suite de cette description élément de détecteurs pyroélectriques, recouvre l'élément 14, appelé élément de photodétecteurs couleur 14. En outre les éléments 14 et 16 recouvrent la matrice de circuits de lecture 124.

Les figures 1 à 8 illustrent un aspect de la présente description dans lequel les éléments 14 et 16 sont empilés l'un au-dessus de l'autre. Ainsi, l'élément 16 de détecteurs pyroélectriques recouvre l'élément 14 de photodétecteurs couleur.

La figure 2 représente par des vues (A) et (B) en perspectives éclatées, partielles et schématiques, deux modes de réalisations d'un pixel 1 de capteur d'images.

A des fins de clarté, seuls les éléments 14 et 16 sont représentés en figure 2.

En vue (A), les deux éléments 14 et 16 sont découpés en quatre sous-pixels. Ainsi dans le pixel 1, l'élément 14 comprend exactement quatre photodétecteurs couleur 1401 et l'élément 16 comprend exactement quatre détecteurs pyroélectriques 1601.

Les détecteurs pyroélectriques 1601 mis en oeuvre dans la présente description utilisent la variation de la température d'une couche dite couche active entrainant une variation de la polarisation électrique dans le matériau de cette même couche. Pour ce fait, les détecteurs pyroélectriques 1601 comprennent une couche absorbeuse de photons infrarouges utilisée pour capter les photons et transmettre à la couche active un flux de chaleur.

La vue (B) diffère de la vue (A) par le fait que l'élément 16 n'est pas divisé en sous-pixels. Cet élément 16, à l'échelle du pixel 1, ne comprend exactement qu'un unique détecteur pyroélectrique 1601. Dans cette même vue (B), l'élément 14 reste divisé en quatre sous-pixels. A l'échelle du pixel 1, cet élément 14 comprend exactement quatre photodétecteurs 1401.

Dans le présent mode de réalisation, un sous pixel est un carré dont les côtés mesurent par exemple entre 0,5 µm et 100 µm, de préférence entre 0,5 µm et 50 µm, plus préférentiellement entre 0,5 µm et 6 µm.

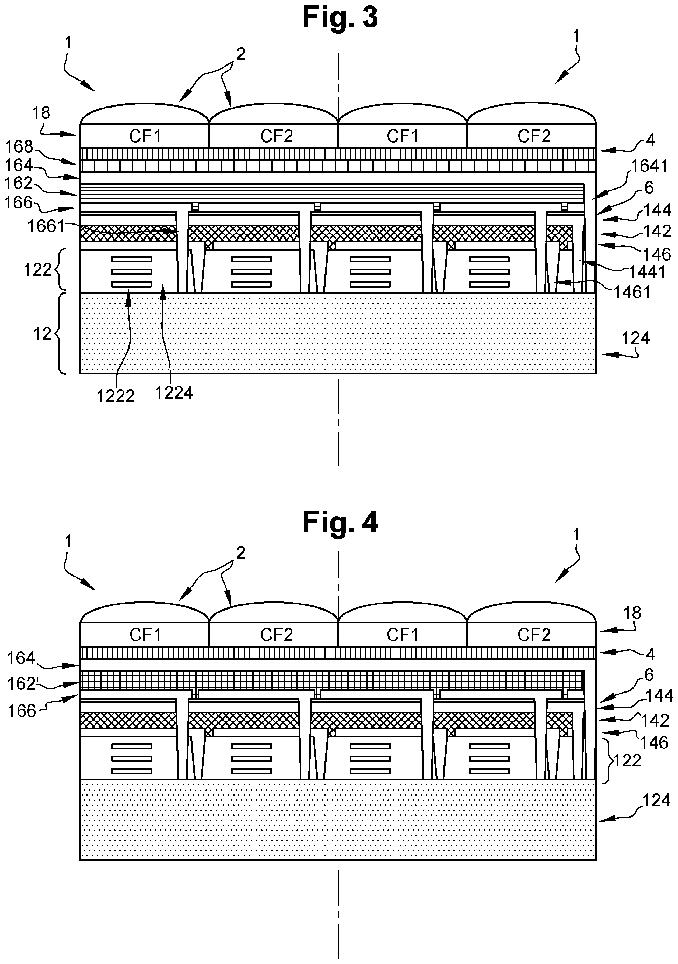

La figure 3 représente une vue en coupe, partielle et schématique, d'un mode de réalisation de deux pixels 1 d'un capteur d'images tel que représenté en figure 2(A).

Deux pixels 1 adjacents sont représentés sur la figure 3. Quatre sous-pixels sont ainsi représentés, les deux sous-pixels de gauche étant identiques aux deux sous-pixels de droite.

Chaque sous-pixel comprend de bas en haut :
- un substrat 12 semiconducteur ;
- des circuits de lecture 124 situés dans le substrat 12 ;
- une portion d'un empilement 122 de couches isolantes 1224 recouvrant le substrat 12, des pistes conductrices 1222 étant situées dans l'empilement 122 entre les couches isolantes 1224 ;
- une électrode 146, reposant sur l'empilement 122 et reliée au substrat ou à l'une des pistes conductrices 1222 par un via conducteur 1461 ;
- une portion d'une couche active 142, adaptée à capter des photons du domaine du visible et du proche-infrarouge, recouvrant pleine plaque toutes les électrodes 146, la couche 142 recouvrant également l'empilement 122 entre chaque électrode 146 d'un sous-pixel et celle du sous-pixel voisin ;
- une portion d'une électrode 144, reposant pleine plaque, sur la couche active 142 et reliée au substrat 12 ou à l'une des piste conductrices 1222 par un via conducteur 1441 ;
- une portion d'une première couche isolante 6, recouvrant pleine plaque toutes les électrodes 144 ;
- une électrode 166, reposant sur la couche isolante 6 et reliée au substrat 12 ou à l'une des pistes conductrice 124 par un via conducteur 1661 ;
- une portion d'une couche active 162 pyroélectriquement, recouvrant pleine plaque toutes les électrodes 166, la couche 162 recouvrant également la couche isolante 6 entre chaque électrode 166 d'un sous-pixel et celle du sous-pixel voisin ;
- une portion d'une électrode 164, reposant pleine plaque, sur la couche active 162 et reliée au substrat 12 ou à l'une des piste conductrices 1222 par un via conducteur 1641 ;
- une portion d'une couche 168, d'absorption du rayonnement infrarouge lointain, dite couche d'absorption IR ;
- une portion d'une deuxième couche isolante 4, dite couche de passivation, recouvrant pleine plaque toutes les électrodes 164 ;
- un filtre couleur 18, optionnel, recouvrant la deuxième couche isolante 4 ; et
- une microlentille 2, recouvrant le filtre couleur 18 ou, le cas échéant, la deuxième couche isolante 4.

Selon le mode de réalisation illustré en figure 3, l'électrode 146, l'électrode 144 et la couche active 142 forment un ou des photodétecteurs 1401 en fonction de la granularité des différentes couches et l'électrode 166, l'électrode 164, la couche active 162 et la couche 168 forment un ou des détecteurs 1601 en fonction de la granularité des différentes couches.

L'électrode 164, représentée commune à plusieurs pixels ou sous-pixels en figure 3 peut, en variante, être différente d'un pixel ou sous-pixel à un autre.

Selon une variante de réalisation, l'électrode 166 est commune à au moins un pixel comme cela est illustré en figure 2 (B). La granularité de l'élément 16 de détecteurs pyroélectriques 1601 est le pixel 1. Il y a alors dans cet élément 16 exactement un seul détecteur pyroélectrique 1601 par pixel.

Dans le mode de réalisation, illustré en figure 3, la couche active 142 est commune à l'ensemble des sous-pixels du capteur d'images. La zone active de chaque photodétecteur couleur 1401 correspond à la zone dans laquelle la majorité du rayonnement incident est absorbée et convertie en signal électrique par le photodétecteur couleur 1401 et correspond sensiblement à la partie de la couche active 142 située entre l'électrode inferieure 146 et l'électrode supérieure 144. En outre, la couche active 162 est commune à l'ensemble des sous-pixels du capteur d'images. La zone active de chaque détecteur pyroélectrique 1601 correspond à la partie de la couche active 162 située entre l'électrode inferieure 166 et l'électrode supérieure 164 dans laquelle la variation de la température de la couche d'absorption IR 168 est détectée et est convertie en signal électrique par le détecteur pyroélectrique 1601.

La couche active 142 est adaptée à capter un rayonnement électromagnétique dans une plage de longueurs d'ondes comprises entre 400 nm et 1,7 µm. La couche active 162 est adaptée à capter un rayonnement électromagnétique dans une plage de longueurs d'ondes comprises entre 1,7 µm et 1 mm. Les détecteurs 1401, 1601 peuvent être réalisés en matériaux organiques. Les photodétecteurs 1401 peuvent correspondre à des photodiodes organiques ou OPD (de l'anglais "Organic PhotoDiode") ou à des photorésistances organiques. Dans la suite de la description, on considère que les photodétecteurs 1401correspondent à des photodiodes.

Les filtres couleur 18 peuvent correspondre à des blocs de résine colorée. Chaque filtre couleur 18 est adapté à laisser passer le rayonnement infrarouge lointain, destiné à la couche d'absorption infrarouge 168 ainsi qu'une partie de la lumière visible selon la couleur considérée. Pour chaque pixel de l'image couleurs à acquérir, le capteur d'images comprend dans ce mode de réalisation :
- un sous-pixel dont le filtre couleur 18 est adapté à ne laisser passer que la lumière bleue, par exemple dans la plage de longueurs d'ondes de 430 nm à 490 nm ;
- un sous-pixel dont le filtre couleur 18 est adapté à ne laisser passer que la lumière rouge, par exemple dans la plage de longueurs d'ondes de 600 nm à 720 nm ; et
- deux sous-pixels dont le filtre couleur 18 est adapté à ne laisser passer que la lumière verte, par exemple dans la plage de longueurs d'onde de 510 nm à 570 nm.

Ces filtres, reliés respectivement chacun à un sous-pixel, s'organisent dans le plan selon la matrice de Bayer. En variante, les filtres couleurs 18 sont organisés selon la matrice de quad-Bayer, de sorte que chaque pixel soit monochrome et divisé en quatre sous-pixels verts, bleus ou rouges.

Dans le présent mode de réalisation, la couche isolante 6 permet d'uniformiser, dans le plan, la distribution thermique de la couche active 162, et de préférence d'isoler totalement, la couche active 162 des circuits de lecture 124 et des détecteurs 1401 qui produisent de la chaleur. La couche 6 a, par exemple, la capacité de réfléchir le rayonnement infrarouge lointain lorsqu'elle est en un métal. La couche isolante 6 correspond, par exemple, à une couche métallique recouverte d'une couche isolante électriquement et recouvrant une couche isolante électriquement.

Selon un mode de réalisation, le substrat 12 semiconducteur est en silicium, de préférence en silicium monocristallin. Le substrat peut être du type silicium sur isolant ou SOI (de l'anglais "Silicon On Insulator") comprenant un empilement d'une couche de silicium (sur une couche isolante). Selon un mode de réalisation, l'empilement 122 comprend des transistors, notamment des transistors MOS.

Les pistes conductrices 1222, les vias conducteurs 1441, 1461, 1641, 1661 et les électrodes 146 peuvent être en un matériau métallique, par exemple l'argent (Ag), l'aluminium (Al), l'or (Au), le cuivre (Cu), le nickel (Ni), le titane (Ti), le chrome (Cr), le nitrure de titane (TiN), le titane-tungstène (TiW), le platine (Pt) ou le tantale (Ta), ou en un oxyde métallique, par exemple, l'oxyde de zinc ou ZnO (de l'anglais "Zinc Oxide"), l'oxyde d'indium-étain ou ITO (de l'anglais "Indium Tin Oxide"), l'oxyde d'aluminium-zinc ou AZO (de l'anglais "Aluminium Zinc Oxide"), l'oxyde de gallium-zinc ou GZO (de l'anglais "Gallium Zinc Oxide"). Les pistes conductrices 1222, les vias conducteurs 1441, 1461, 1641, 1661 et les électrodes 146 peuvent avoir une structure monocouche ou multicouche. Chaque couche isolante de l'empilement 122 peut être en un matériau inorganique, par exemple en oxyde de silicium (SiO₂) ou un nitrure de silicium (SiN).

Chaque électrode 144, 164, 166 est au moins partiellement transparente au rayonnement lumineux que la couche active 142 reçoit. Chaque électrode 144, 164, 166 peut être en un matériau conducteur et transparent, par exemple en oxyde conducteur et transparent ou TCO (de l'anglais "Transparent Conductive Oxide"), en nanotubes de carbone, en graphène, en un polymère conducteur, en un métal, ou en un mélange ou un alliage d'au moins deux de ces composés. Chaque électrode 144, 164, 166 peut avoir une structure monocouche ou multicouche.

Des exemples de d'oxyde conducteurs et transparents adaptés à la réalisation de chaque électrode 144, 164, 166 sont l'oxyde d'indium-étain ou ITO (de l'anglais "Indium Tin Oxide"), l'oxyde d'aluminium-zinc ou AZO (de l'anglais "Aluminium Zinc Oxide"), l'oxyde de gallium-zinc ou GZO (de l'anglais "Gallium Zinc Oxide"), le nitrure de titane (TiN), l'oxyde de molybdène (MoO₃) et l'oxyde de tungstène (WO₃). Un exemple de polymère conducteur adapté à la réalisation de chaque électrode 144, 164, 166 est le polymère connu sous la dénomination PDOT:PSS, qui est un mélange de poly(3,4)-éthylènedioxythiophène et de polystyrène sulfonate de sodium et la polyaniline, également appelé PAni. Des exemples de métaux adaptés à la réalisation de chaque électrode 144, 164, 166 sont l'argent, l'aluminium, l'or, le cuivre, le nickel, le titane et le chrome. Un exemple de structure multicouche adaptée à la réalisation de chaque électrode 144, 164, 166 est une structure multicouche d'AZO et d'argent de type AZO/Ag/AZO. A titre d'exemple, l'électrode 164 est en PDOT:PSS, en dioxyde d'étain (SnO₂), en chrome (Cr), en nickel noir (en anglais "black nickel"), en graphite ou en or noir (en anglais "black gold") .

L'épaisseur de chaque électrode 144, 164, 166 peut être comprise entre 10 nm et 5 µm, par exemple comprise entre 30 nm et 60 nm. Dans le cas où l'électrode 144, 164, 166 est métallique, l'épaisseur de l'électrode 144, 164, 166 est comprise entre 1 nm et 1 µm, de préférence comprise entre 10 nm et 100 nm.

Chaque couche isolante 4, 6 peut être réalisée en polymère fluoré, notamment le polymère fluoré commercialisé sous l'appellation Cytop par la société Bellex, en polyvinylpyrrolidone (PVP), en polyméthacrylate de méthyle (PMMA), en polystyrène (PS), en parylène, en polyimide (PI), en acrylonitrile butadiène styrène (ABS), en polytéréphtalate d'éthylène (PET, en poly(naphtalate d'éthylène) (PEN), en polymères d'oléfine cyclique ou COP (de l'anglais "Cyclo Olefin Polymer"), en polydiméthylsiloxane (PDMS), en une résine de photolithographie, en résine époxy, en résine acrylate ou en un mélange d'au moins deux de ces composés. A titre de variante, chaque couche isolante 4, 6 peut être réalisée en un diélectrique inorganique, notamment en nitrure de silicium (SiN), en dioxyde de silicium (SiO₂) ou en oxyde d'aluminium (Al₂O₃). L'oxyde d'aluminium peut être déposé par dépôt de couches minces atomiques ou ALD (de l'anglais "Atomic Layer Deposition"). L'épaisseur maximale de chaque couche isolante 4, 6 peut être comprise entre 5 nm et 2 µm, par exemple de l'ordre de 25 nm.

La couche active 142 peut comprendre des petites molécules, des oligomères ou des polymères. Il peut s'agir de matériaux organiques ou inorganiques, notamment des boîtes quantiques. La couche active 142 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la couche active 142 peut être comprise entre 100 nm et 10 µm, de préférence entre 250 nm et 5 µm et préférentiellement entre 250 nm et 600 nm.

Des exemples de polymères semiconducteurs de type P adaptés à la réalisation de la couche active 142 sont :
- le poly(3-hexylthiophène) (P3HT) ;
- le poly[N-9'-heptadécanyl-2,7-carbazole-alt-5,5-(4,7-di-2-thiényl-2',1',3'-benzothiadiazole)] (PCDTBT) ;
- le poly[(4,8-bis-(2-éthylhexyloxy)-benzo[1,2-b;4,5-b'] dithiophène)-2,6-diyl-alt-(4-(2-éthylhexanoyl)-thieno[3,4-b] thiophène))-2,6-diyl] (PBDTTT-C) ;

- le poly[2-méthoxy-5-(2-éthyl-hexyloxy)-1,4-phénylène-vinylène] (MEH-PPV) ; ou
- le poly[2,6-(4,4-bis-(2-éthylhexyl)-4H-cyclopenta [2,1-b;3,4-b']dithiophène)-alt-4,7(2,1,3-benzothiadiazole)] (PCPDTBT) .

Des exemples de matériaux semiconducteurs de type N adaptés à la réalisation de la couche active 142 sont les fullerènes, notamment le C60, le [6,6]-phényl-C61-butanoate de méthyle ([60]PCBM), le [6,6]-phényl-C71-butanoate de méthyle ([70]PCBM), le pérylène diimide, l'oxyde de zinc (ZnO) ou des nanocristaux permettant la formation de boîtes quantiques (en anglais "quantum dots").

La couche active 162 peut comprendre des petites molécules, des oligomères ou des polymères. Il peut s'agir, comme dans le cas de la couche active 142, de matériaux organiques ou inorganiques. La couche active 162 comprend un matériau piézoélectrique et pyroélectrique. La couche active 162 peut notamment être en polyfluorure de vinylidène (PVDF) ou un de ses copolymères ou terpolymères. Le copolymère ou terpolymère étant de préférence un copolymère de fluorure de vinylidène et de trifluoroéthylène (P(VDF-TrFE)), un copolymère de fluorure de vinylidène et de chlorure de trifluoroéthylène (P(VDF-CTFE)), un copolymère de fluorure de vinylidène et de hexafluoropropylène (P(VDF-HFP)), un terpolymère de fluorure de vinylidène et de trifluoroéthylène et de chlorofluoroéthylene P(VDF-TrFE-CFE), ou un mélange d'au moins deux de ces copolymères/terpolymères.

L'épaisseur de la couche active 162 peut être comprise entre 100 nm et 100 µm, par exemple entre 500 nm et 10 µm et de préférence entre 500 nm et 5 µm.

A titre de variante, la couche active 162 peut contenir du polyfluorure de vinyle (PVF), du polychlorure de vinyle (PVC), du titanate de baryum, du titano-zirconate de plomb (PZT), du tantalate de lithium (LT) du sulfate de triglycine (TGS), du titanate de plomb, du fluorure de vinylidène trifluoroéthylène (VF₂VF₃), ou un mélange d'au moins deux de ces composés.

La couche d'absorption IR 168, absorbe les ondes électromagnétiques dans la plage de longueurs d'ondes de 1 µm à 1 mm. Cette couche d'absorption IR 168, présente au-dessus des deux couches actives 142 et 162, est transparent dans le visible et, de préférence, dans le proche infrarouge. La couche d'absorption IR 168 est en dioxyde de silicium (SiO₂), en dioxyde de silicium dopé avec de l'antimoine (Sb-SiNO₂), en PDOT:PSS, en chrome (Cr), en nickel noir (en anglais "black nickel"), en graphite ou en or noir (en anglais "black gold). La couche d'absorption IR 168 a, de préférence, une épaisseur suffisamment fine afin d'être transparente dans le rayonnement visible et, de préférence, proche infrarouge. Dans le mode de réalisation de la figure 3, la couche d'absorption IR 168 recouvre l'électrode 164 du détecteur pyroélectrique 1601. L'électrode 164 étant un bon conducteur thermique, la chaleur est véhiculée suffisamment efficacement, jusqu'à la couche active 162.

Les microlentilles 2 sont de taille micrométrique. Dans le présent mode de réalisation, chaque sous-pixel comprend une microlentille 2. A titre de variante, chaque microlentille 2 peut être remplacée par un autre type d'élément optique de taille micrométrique, notamment une lentille de Fresnel de taille micrométrique, une lentille à gradient d'indice de taille micrométrique ou un réseau de diffraction de taille micrométrique. Les microlentilles 2 sont des lentilles convergentes ayant chacune une distance focale f comprise entre 1 µm et 100 µm, de préférence entre 1 µm et 10 µm. Selon un mode de réalisation, toutes les microlentilles 2 sont sensiblement identiques.

Les microlentilles 2 peuvent être réalisées en silice, en PMMA, en une résine photosensible positive, en PET, en PEN, en COP, en PDMS/silicone, ou en résine époxy. Les microlentilles 2 peuvent être formées par fluage de blocs d'une résine photosensible. Les microlentilles 2 peuvent en outre être formées par moulage sur une couche de PET, PEN, COP, PDMS/silicone ou résine époxy.

Selon les matériaux considérés, le procédé de formation d'au moins certaines couches du pixel 1 de capteur d'images peut correspondre à un procédé dit additif, par exemple par impression directe du matériau composant les couches organiques aux emplacements souhaités notamment sous forme de sol-gel, par exemple par impression par jet d'encre, héliographie, sérigraphie, flexographie, revêtement par pulvérisation (en anglais "spray coating") ou dépôt de gouttes (en anglais "drop-casting"). Selon les matériaux considérés, le procédé de formation des couches du pixel 1 de capteur d'images peut correspondre à un procédé dit soustractif, dans lequel le matériau composant les couches organiques est déposé sur la totalité de la structure et dans lequel les portions non utilisées sont ensuite retirées, par exemple par photolithographie ou ablation laser. En outre, selon les couches et les matériaux considérés, le matériau composant les couches actives 14, 16 est déposé sur la totalité de la structure et n'est pas partiellement retiré, le pas des photodiodes étant alors obtenu par la position des électrodes 166 et 146. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette (en anglais "spin coating"), revêtement par pulvérisation, héliographie, revêtement par filière (en anglais "slot-die coating"), revêtement à la lame (en anglais "blade-coating"), flexographie ou sérigraphie. Lorsque les couches sont métalliques, le métal est, par exemple, déposé par évaporation ou par pulvérisation cathodique sur l'ensemble du support et les couches métalliques sont délimitées par gravure. A titre d'exemple, la couche active 162 est formée par un procédé de laminage.

De façon avantageuse, au moins certaines des couches du capteur d'images 1 peuvent être réalisées par des techniques d'impression. Les matériaux de ces couches décrites précédemment peuvent être déposés sous forme liquide, par exemple sous forme d'encres conductrices et semiconductrices à l'aide d'imprimantes à jet d'encre. Par matériaux sous forme liquide, on entend ici également des matériaux en gel déposables par des techniques d'impression. Des étapes de recuit sont éventuellement prévues entre les dépôts des différentes couches, mais les températures de recuit peuvent ne pas dépasser 150°C, et le dépôt et les éventuels recuits peuvent être réalisés à la pression atmosphérique.

Selon une variante de réalisation, une couche métallique suffisamment fine pour laisser passer la lumière visible sert à homogénéiser la température dans le plan. Cette couche est située, par exemple, entre la couche 6 et l'électrode 166 ou entre l'électrode 144 et la couche d'isolation 6 ou entre deux couches 6. La couche métallique a, en outre, un rôle de réflecteur thermique.

Selon une autre variante de réalisation, l'élément 14 de photodétecteurs couleur 1401 et l'élément 16 de détecteurs pyroélectriques 1601 sont inversés. L'élément de 14 recouvre l'élément 16. Les matériaux sont ainsi adaptés de sorte que les couches 4, 142, 6 et les électrodes 144, 146 déposées au-dessus de la couche d'absorption IR 168 n'absorbent pas le rayonnement infrarouge lointain.

La figure 4 représente une vue en coupe, partielle et schématique, d'un autre mode de réalisation de deux pixels 1 d'un capteur d'images tel que représenté en figure 2(A).

Le présent mode de réalisation diffère du mode de réalisation illustré en figure 3 par le fait que la couche d'absorption IR 168 est incluse dans la couche active pyroélectriquement désignée ici 162'. Cette couche 162' est un mélange de la couche 162 et la couche d'absorption IR 168 de la figure 3 composées par exemple des matériaux cités ci-avant. Elle peut notamment être en un composite de PVDF et nanoparticules de SnO₂.

Le matériau de l'électrode 164 est adapté à laisser passer le rayonnement infrarouge lointain.

Les différentes variantes décrites en relation avec le mode de réalisation représenté en figure 3, se transposent au présent mode de réalisation.

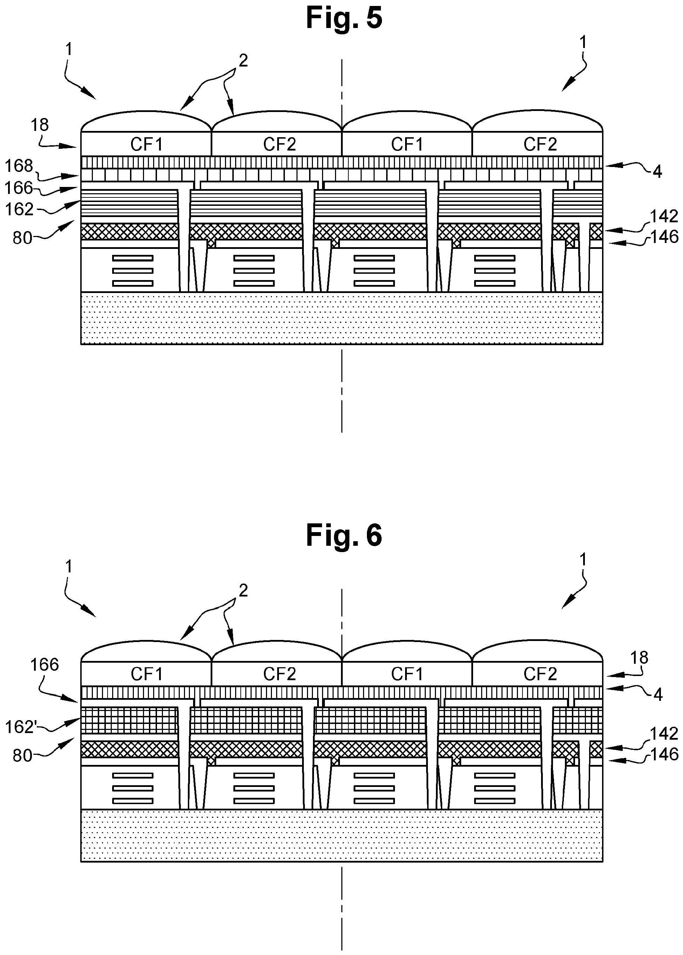

La figure 5 représente une vue en coupe, partielle et schématique, d'un autre mode de réalisation de deux pixels 1 d'un capteur d'images tel que représenté en figure 2(A).

Le présent mode de réalisation diffère du mode de réalisation illustré en figure 3 par le fait que les deux couches actives 142, 162 partagent une électrode 80 dite électrode commune.

L'électrode commune 80 remplace les électrodes pleines plaques 144, 164 de la figure 3 et est située entre les deux couches actives 142, 162. L'électrode 166 initialement située sous la couche active 162, recouvre, dans le présent mode de réalisation, la couche active 162 qui elle-même recouvre l'électrode commune 80. En outre, la couche d'isolation 6 entre les deux éléments 14, 16 n'est plus nécessaire.

Les différentes variantes décrites en relation avec le mode de réalisation représenté en figure 3, se transposent au présent mode de réalisation.

La figure 6 représente une vue en coupe, partielle et schématique, d'un autre mode de réalisation de deux pixels 1 d'un capteur d'images tel que représenté en figure 2(A).

Le présent mode de réalisation, diffère du mode de réalisation illustré en figure 5 par le fait que la couche d'absorption IR 168 est, comme en figure 4, incluse dans la couche active désignée ici 162'. Cette couche 162' est un mélange de la couche 162 et la couche d'absorption IR 168 de la figure 3 composées par exemple des matériaux cités ci-avant. Elle peut notamment être en composite de PVDF et nanoparticules de SnO₂.

Le matériau de l'électrode 166 est alors adapté à laisser passer le rayonnement infrarouge lointain.

Les différentes variantes décrites en relation avec le mode de réalisation représenté en figure 3, se transposent au présent mode de réalisation.

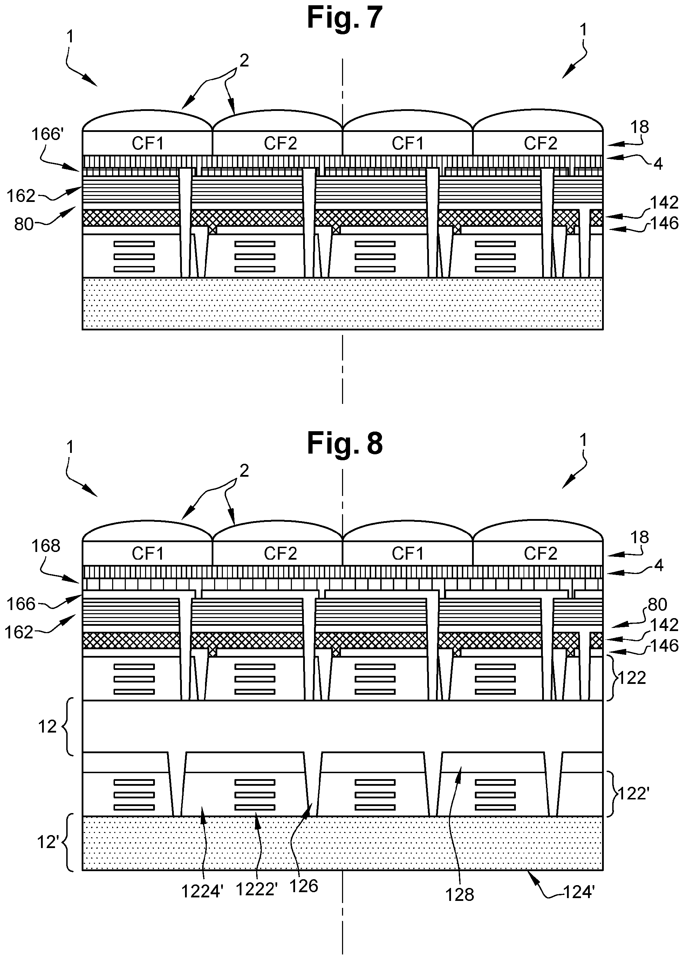

La figure 7 représente une vue en coupe, partielle et schématique, d'un autre mode de réalisation de deux pixels 1 d'un capteur d'images tel que représenté en figure 2(A).

Le présent mode de réalisation diffère du mode de réalisation illustré en figure 5 par le fait que la couche d'absorption IR 168 est incluse dans l'électrode haute, désignée ici 166'. Cette électrode est un mélange de l'électrode 166 et de la couche d'absorption IR 168 de la figure 5. Elle peut notamment être à base de SnO₂.

Selon autre variante, non représentée, la couche d'absorption IR 168 fait partie de l'électrode commune 80. Elle peut notamment être à base de SnO₂.

Les différentes variantes décrites en relation avec le mode de réalisation représenté en figure 3, se transposent au présent mode de réalisation.

La figure 8 représente une vue en coupe, partielle et schématique, d'un autre mode de réalisation de deux pixels 1 d'un capteur d'images tel que représenté en figure 2(A).

Le présent mode de réalisation diffère du mode de réalisation illustré en figure 3 par le fait qu'une puce électronique, constituée d'un substrat 12' et d'un empilement 122' de niveaux de métallisations de distribution de signaux, est ajoutée sous le substrat 12. L'empilement 122' et le substrat 12' comprennent :
- des circuits de lecture 124' situés dans le substrat 12' ;
- un empilement 122' de couches isolantes 1224' recouvrant le substrat 12', des pistes conductrices 1222' étant situées dans l'empilement 122' entre les couches isolantes 1224' ;
- des vias 126 situés entre les empilements 122' de chaque sous-pixel, permettent de relier les deux puces ; et
- un diélectrique 128, recouvrant localement les empilements 122'.

L'ensemble comprenant l'empilement 122' et le substrat 12' intègre des circuits numériques tels que des amplificateurs de pied de colonne, des convertisseurs analogique-numérique ou ADC (de l'anglais "Analog Digital Converter") et des unités de traitement. Ce mode de réalisation permet notamment d'isoler les circuits ou composés chauffants lorsqu'ils sont actifs et pouvant perturber la polarisation électrique de la couche active 162 qui est pyroélectrique.

Le diélectrique 128 peut notamment être à base d'aérogel ou d'un isolant inorganique tel que le dioxyde de silicium (SiO₂) ou le nitrure de silicium (SiN) et mesurer de préférence entre 1 µm et 900 µm, par exemple de l'ordre de 500 µm d'épaisseur.

Les différentes variantes décrites en relation avec les modes de réalisation représentés aux figures 3 à 7, se transposent au présent mode de réalisation.

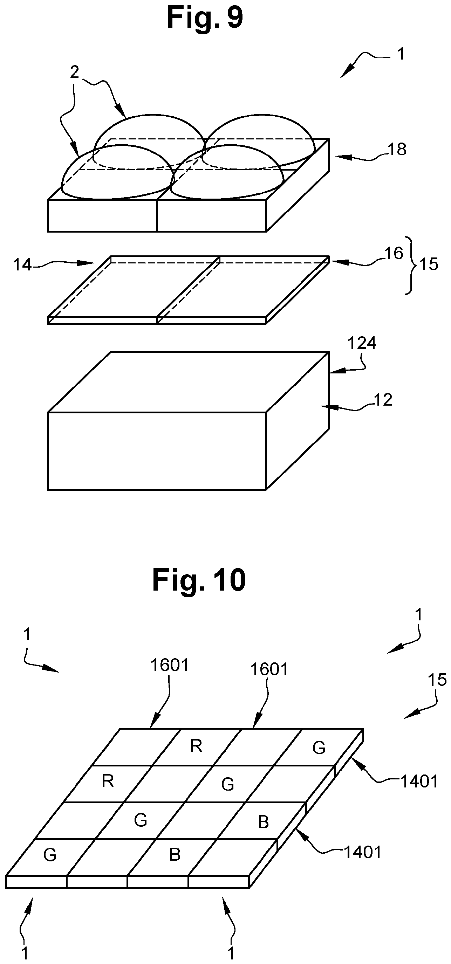

La figure 9 représente une vue en perspective éclatée, partielle et schématique, d'un autre mode de réalisation d'un pixel 1 de capteur d'images couleur et pyroélectrique.

Les figures 9 à 16 illustrent un autre aspect de la présente description dans lequel les éléments 14 et 16 sont coplanaires au sein de la même couche 15.

Le pixel 1 de capteur d'images comprend de bas en haut :
- un substrat 12 semi-conducteur ;
- des circuits de lecture 124 situés sur et dans le substrat 12 ;
- un premier élément 14 de plusieurs capteurs de photons, adaptés à capter une image couleur dans le visible et proche infrarouge et un deuxième élément 16 de plusieurs détecteurs adaptés à capter une image d'infrarouge lointain ;
- des filtres couleur 18 ; et
- des microlentilles 2 recouvrant les filtres couleur.

La figure 10 représente par une vue en perspective éclatée, partielle et schématique, un mode de réalisation d'un pixel 1 de capteur d'images.

A des fins de clarté, seuls les éléments 14 et 16 sont représentés en figure 10.

Quatre pixels adjacents sont représentés sur la figure 10. Chaque pixel est divisé en quatre sous-pixels. Deux sous-pixels sont des photodétecteurs couleur 1401 monochromes tandis que deux autres des détecteurs pyroélectriques 1601. Les sous-pixels sont organisés de sorte que les deux photodétecteurs 1401 monochromes soient diagonalement opposés au sein du pixel carré, les détecteurs pyroélectriques 1601 sont également diagonalement opposés au sein du même pixel.

Dans le présent mode de réalisation, un détecteur 1401, 1601 est un carré dont les côtés mesurent par exemple entre 0,5 µm et 100 µm, de préférence entre 0,5 µm et 50 µm, plus préférentiellement entre 0,5 µm et 6 µm.

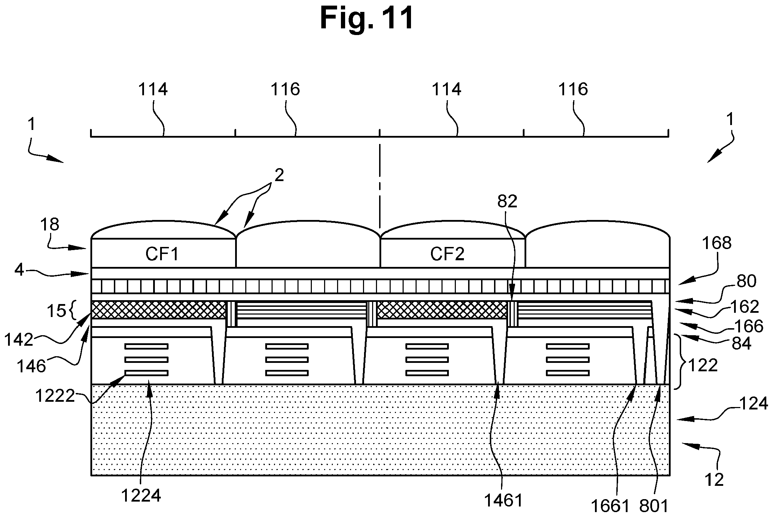

La figure 11 représente une vue en coupe, partielle et schématique, d'un mode de réalisation de deux pixels 1 d'un capteur d'images tel que représenté en figure 10.

Deux pixels adjacents sont représentés sur la figure 11. Quatre sous-pixels sont ainsi représentés. Les deux sous-pixels de gauche 114, 116 sont différentes l'un de l'autre. De même les deux sous-pixels de droite 116, 114 sont différents.

Chaque sous-pixel 114 comprend de bas en haut :
- un substrat 12 semiconducteur ;
- des circuits de lecture 124, situés dans le substrat 12 ;
- un empilement 122 de couches isolantes 1224 recouvrant le substrat 12, des pistes conductrices 1222 étant situées dans l'empilement 122 entre les couches isolantes 1224 ;
- une portion d'une première couche isolante 84, recouvrant pleine plaque les empilements 122 ;
- une électrode 146, reposant sur la portion de la première couche isolante 84, reliée au substrat ou à l'une des pistes conductrices 1222 par un via conducteur 1461 ;
- une couche active 142, recouvrant l'électrode 146 ;
- une portion d'une électrode 80, reposant pleine plaque sur la couche active 142, reliée au substrat 12 ou à l'une des piste conductrices 1222 par un via conducteur 801 ;
- une portion d'une couche ayant des propriétés d'absorption infrarouge 168, recouvrant pleine plaque l'électrode 80 ;
- une portion d'une deuxième couche isolante 4, dite couche de passivation, recouvrant pleine plaque la couche d'absorption IR 168 ;
- un filtre couleur 18, recouvrant la portion de la deuxième couche isolante 4 ; et
- une microlentille 2, recouvrant le filtre couleur 18.

Chaque sous-pixel 116 comprend, de même, de bas en haut :
- un substrat 12, semiconducteur ;
- des circuits de lecture 124, situés dans le substrat 12 ;
- un empilement 122, de couches isolantes 1224 recouvrant le substrat 12, des pistes conductrices 1222 étant situées dans l'empilement 122 entre les couches isolantes 1224 ;
- une portion d'une première couche isolante 84, recouvrant pleine plaque les empilements 122 ;
- une électrode 166, reposant sur la portion de la première couche isolante 84, reliée au substrat ou à l'une des pistes conductrices 1222 par un via conducteur 1661 ;
- une couche active 162, recouvrant l'électrode 166 ;
- une portion d'une électrode 80, reposant pleine plaque, sur la couche active 162, reliée au substrat 12 ou à l'une des piste conductrices 1222 par un via conducteur 801 ;
- une portion d'une couche ayant des propriétés d'absorbeur infrarouge 168, recouvrant pleine plaque l'électrode 80 ;
- une portion d'une deuxième couche isolante 4, dite couche de passivation, recouvrant pleine plaque la couche d'absorption IR 168 ; et
- une microlentille 2, recouvrant la portion de la deuxième couche isolante 4.

Un diélectrique 82 isole chaque sous-pixel en séparant, dans le plan, les couches actives 142 et les électrodes 146 des couches actives 162 et des électrodes 166.

Le diélectrique 82 peut être un isolant ou un réflecteur thermique ou optique, à titre d'exemple, il peut être du SiN ou du SiO₂.

Les filtres couleur 18 sont adaptés à laisser passer une partie de la lumière visible selon la couleur considérée. Chaque pixel est monochromatique. Pour chaque ensemble de quatre pixels de l'image couleurs à acquérir, le capteur d'images comprend dans ce mode de réalisation :
- deux sous-pixels dont le filtre couleur 18 est adapté à ne laisser passer que la lumière bleue, par exemple dans la plage de longueurs d'ondes de 430 nm à 490 nm ;
- deux sous-pixels dont le filtre couleur 18 est adapté à ne laisser passer que la lumière rouge, par exemple dans la plage de longueurs d'ondes de 600 nm à 720 nm ; ou
- deux sous-pixels dont le filtre couleur 18 est adapté à ne laisser passer que la lumière verte, par exemple dans la plage de longueurs d'onde de 510 nm à 570 nm.

Les pixels 1 du capteur, illustré en figure 10, s'organisent entre eux, dans le plan, selon la matrice de Bayer.

Les couches actives 142 et 162 ont les mêmes propriétés et les mêmes compositions que les couches actives respectivement 142 et 162 décrites dans le mode de réalisation illustré par la figure 3.

Le matériau composant les couches actives 142, 162 peut être déposé, selon les techniques décrites dans le mode de réalisation de la figure 3, en dépôt sur la totalité de la structure en étant partiellement retiré ou en dépôt localisé.

Les couches isolantes 84 et 4 ont les mêmes propriétés, les mêmes compositions et les mêmes procédés de formation que les couches isolantes décrites dans le mode de réalisation illustré par la figure 3.

Les pistes conductrices 1222, les vias 1461, 1661, 801 et les électrodes 146, 166, 80 ont les mêmes propriétés, les mêmes compositions et les mêmes procédés de formation respectivement que les pistes conductrices, les vias et les électrodes décrits dans le mode de réalisation illustré par la figure 3.

Les microlentilles 2, ont les mêmes propriétés, les mêmes compositions et les mêmes procédés de formation que les microlentilles décrites dans le mode de réalisation illustré par la figure 3.

Le substrat 12 a les mêmes propriétés, la même composition et le même procédé de formation que le substrat décrit dans le mode de réalisation illustré par la figure 3.

Selon une variante de réalisation, les électrodes 146 et 166, différentes d'un sous-pixel ou pixel à l'autre, peuvent être respectivement communes aux autres électrodes des sous-pixels de même type.

L'électrode 80, représentée commune à plusieurs pixels ou sous-pixel en figure 11 peut, en variante, être différente d'un pixel ou sous-pixel à un autre. Ainsi la portion d'électrode 80 située au-dessus de la couche active 142 peut être à base d'un matériau ne laissant pas passer le rayonnement infrarouge lointain. De la même façon, la portion d'électrode 80 située au-dessus de la couche active 162 peut être à base d'un matériau ne laissant pas passer le rayonnement visible.

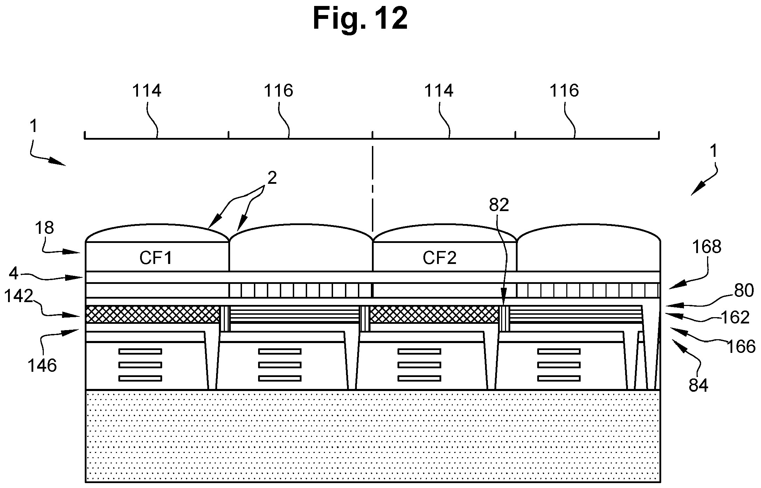

La figure 12 représente une vue en coupe, partielle et schématique, d'un autre mode de réalisation de deux pixels 1 d'un capteur d'images tel que représenté en figure 10.

Le présent mode de réalisation diffère du mode de réalisation illustré en figure 5 par le fait que la couche d'absorption IR 168 ne recouvre sélectivement que les sous-pixels contenant un détecteur pyroélectrique.

La couche d'absorption IR 168 peut alors être indifféremment transparente dans le visible, comme évoqué dans le mode de réalisation illustré par la figure 3, ou opaque dans le visible. Dans ce dernier cas, la couche d'absorption IR 168 peut être à base de graphite, de nickel noir ou d'or noir.

Les différentes variantes décrites, en relation avec le mode de réalisation représenté en figure 11, se transposent au présent mode de réalisation.

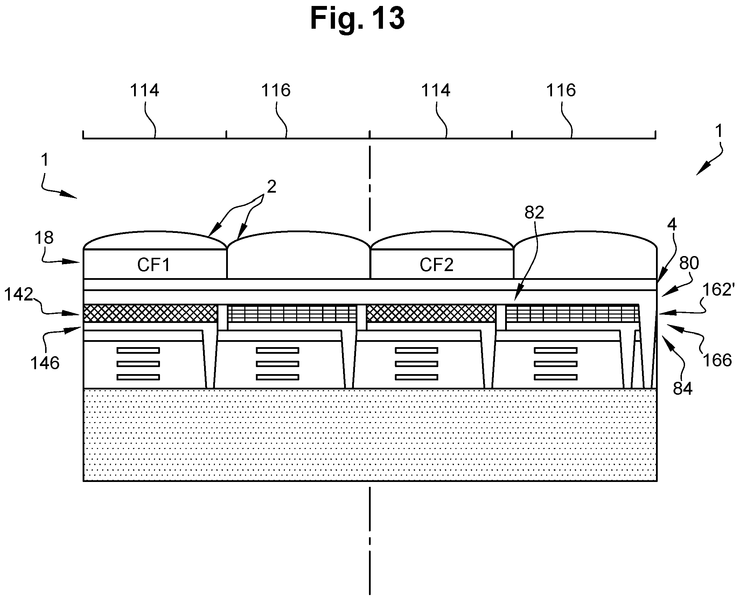

La figure 13 représente une vue en coupe, partielle et schématique, d'un autre mode de réalisation de deux pixels 1 d'un capteur d'images tel que représenté en figure 10.

Le présent mode de réalisation diffère du mode de réalisation illustré en figure 11 par le fait que la couche d'absorption IR 168 est incluse dans la couche désignée ici 162'. Cette couche 162' est un mélange de la couche 162 et la couche d'absorption IR 168 de la figure 11 composées par exemple des matériaux cités ci-avant. Elle peut notamment être en un composite de PVDF et nanoparticules de SnO₂.

Les différentes variantes, décrites en relation avec le mode de réalisation représenté en figure 11, se transposent au présent mode de réalisation.

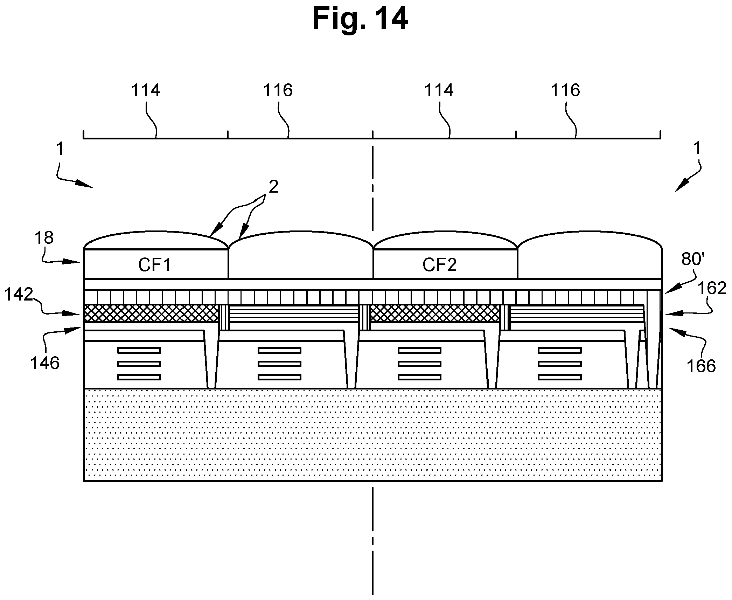

La figure 14 représente une vue en coupe, partielle et schématique, d'un autre mode de réalisation de deux pixels 1 d'un capteur d'images tel que représenté en figure 10.

Le présent mode de réalisation diffère du mode de réalisation illustré en figure 11 par le fait que la couche d'absorption IR 168 est incluse dans l'électrode haute, désignée ici 80'. Cette électrode est un mélange de l'électrode commune 80 et de la couche d'absorption IR 168 de la figure 11. Elle peut notamment être à base de SnO₂. Dans ce mode de réalisation, les matériaux sont adaptés et l'électrode 80' est fabriquée dans un matériau transparent dans le visible.

Selon autre variante, non représentée, la couche d'absorption IR 168 fait partie de l'électrode 166. Elle peut notamment être à base de SnO₂.

Les différentes variantes, décrites en relation avec le mode de réalisation représenté en figure 11, se transposent au présent mode de réalisation.

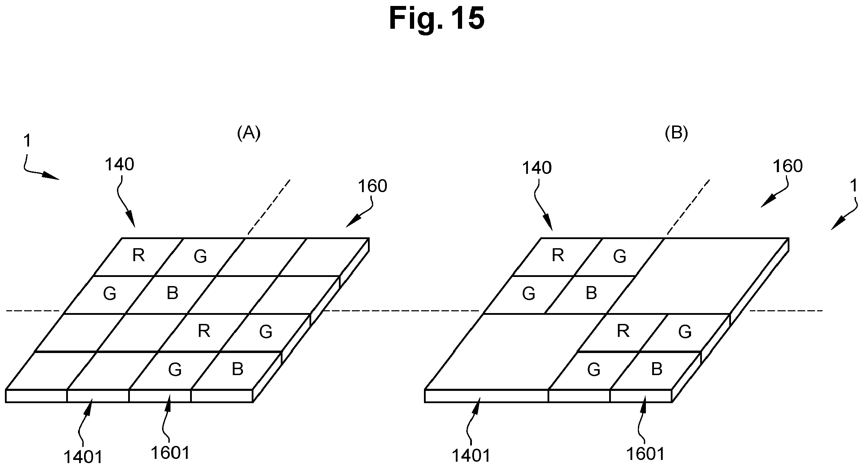

La figure 15 représente par des vues (A) et (B) en perspective éclatée, partielles et schématiques, deux modes de réalisations d'un pixel 1 de capteur d'images.

Le pixel 1 est découpé en quatre sous-pixels.

En vue (A), chaque pixel 1 comprend deux sous-pixels 140 de photodétecteurs couleur 1401 et deux sous-pixels 160 de détecteurs pyroélectriques 1601.

Les sous-pixels sont organisés de sorte que les deux sous-pixels 140 de photodétecteurs couleur 1401 soient diagonalement opposés au sein du pixel 1 carré, les sous-pixels 160 de détecteurs pyroélectriques 1601 sont également diagonalement opposés au sein du pixel carré.

Chaque sous-pixel 140 de photodétecteurs couleurs 1401 est divisé en quatre parties, de même pour chaque sous-pixel 160 de détecteurs pyroélectriques 1601. Ainsi, dans ce mode de réalisation et au sein d'un pixel, il y a exactement huit photodétecteurs couleur 1401 et exactement huit détecteurs pyroélectriques 1601. Les quatre photodétecteurs 1401 de chaque partie de sous-pixels se répartissent en une partie bleue, une partie rouge et deux parties vertes agencées en matrice de Bayer.

La vue (B) diffère de la vue (A) par le fait que les sous-pixels 160 de détecteurs pyroélectriques 1601 ne sont pas divisés en partie de sous-pixels, leur granularité est le sous-pixel. Ainsi, dans ce mode de réalisation et au sein d'un pixel, il y a exactement huit photodétecteurs couleur 1401 et exactement deux détecteurs pyroélectriques 1601.

Dans les vues (A) et (B) de la figure 15, un sous-pixel peut également être considéré comme un pixel et un pixel comme un groupe de quatre pixels. Alors, dans les vues (A) et (B), sont représentés deux pixels de photodétecteurs couleur et deux pixels de détecteurs pyroélectriques.

Dans le présent mode de réalisation, un détecteur 1401, 1601 est un carré dont les côtés mesurent par exemple entre 0,5 µm et 100 µm, de préférence entre 0,5 µm et 50 µm, plus préférentiellement entre 0,5 µm et 6 µm.

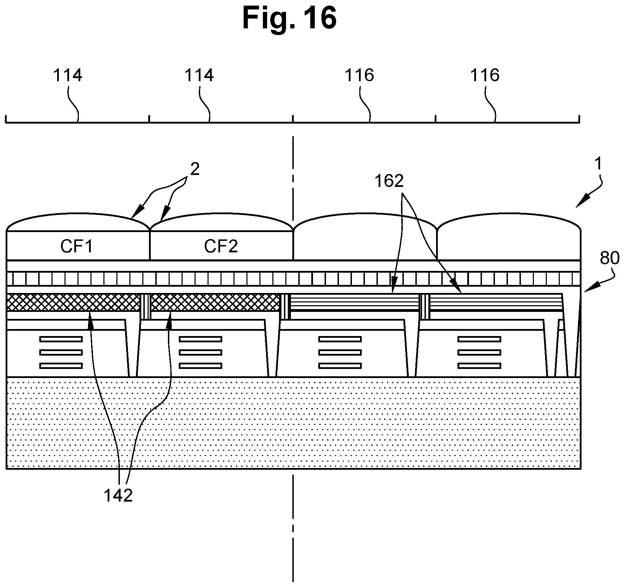

La figure 16 représente une vue en coupe, partielle et schématique, d'un autre mode de réalisation d'un pixel 1 d'un capteur d'images tel que représenté en figure 15(A).

Le présent mode de réalisation, diffère du mode de réalisation illustré en figure 11, par le fait que les pixels et sous-pixels sont organisés différemment dans le plan. Sur la figure 16, quatre parties de sous-pixels sont représentées. Les deux parties de sous-pixels de gauche représentent deux unités de photo-détection couleur 114. Les deux parties de sous-pixels de droite représentent deux unités de détection pyroélectrique 116.

Les unités 114, 116 sont identiques aux unités 114, 116 du mode de réalisation présenté en figure 11.

Les différentes variantes décrites en relation avec le mode de réalisation représenté en figures 11 à 14, se transposent au présent mode de réalisation. Pour appliquer ces différentes variantes, l'homme du métier prendra soin de différencier un pixel et un sous pixel dans les figures 11 à 14 et un pixel et un sous-pixel dans les figures 15 et 16.

Le mode de réalisation illustré en figure 8 peut se décliner dans les variantes de réalisation présentées en figures 11 à 16.

Un avantage des modes de réalisation décrits est d'enrichir les données captées par le capteur. Les applications qui en découlent sont par exemple la détection d'empreintes digitales et la reconnaissance de fausses empreintes digitales.

Un autre exemple d'application est la détection événementielle de voitures et piétons pour l'automobile.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art.

Enfin, la mise en œuvre pratique des modes de réalisation et variantes décrits est à la portée de l'homme du métier à partir des indications fonctionnelles données ci-dessus.

## Revendications

1. Pixel (1) formé de plusieurs sous-pixels et comprenant :
au moins un détecteur pyroélectrique (1601) comprenant une première couche active (162) ; et
au moins un photodétecteur couleur (1401) organique comprenant une deuxième couche active (142),
chaque sous-pixel comprenant :
- une première électrode (146) et une deuxième électrode (144, 80) qui sont, dans l'épaisseur, de part et d'autre de la deuxième couche active (142) et délimitent une photodiode (1401) ; et
- une troisième électrode (166) et une quatrième électrode (164, 80) qui sont, dans l'empilement, de part et d'autre de la première couche active (162) et délimitent un détecteur (1601).

2. Pixel selon la revendication 1 dans lequel la deuxième (80) et la quatrième électrode (80) sont communes.

3. Pixel selon la revendication 1 ou 2, comprenant exactement quatre photodétecteurs couleur (1401), empilés avec un ou exactement quatre détecteurs pyroélectriques (1601).

4. Pixel selon l'une quelconque des revendications 1 à 3, dans lequel les photodétecteurs (1401) et le ou les détecteurs pyroélectriques (1601) recouvrent un substrat (12) qui contient des circuits de lecture (124) en technologie CMOS.

5. Pixel selon la revendication 4, dans lequel chaque électrode (144, 146, 164, 166, 80, 166', 80') est reliée au substrat (12) par au moins un via conducteur (1441, 1461, 1641, 1661, 801, 1661', 801').

6. Pixel selon l'une quelconque des revendications 1 à 5, dans lequel les photodétecteurs (1401) sont configurés pour absorber les ondes électromagnétiques du visible et d'une première partie du spectre infrarouge, dont la longueur d'onde est, de préférence comprise entre 700 nm et 1,7 µm et dans lequel le ou les détecteurs pyroélectriques (1601) sont configurés pour absorber le rayonnement électromagnétique d'une deuxième partie du spectre infrarouge dont la longueur d'onde est, de préférence comprise entre 1,7 µm et 1 mm.

7. Pixel selon l'une quelconque des revendications 1 à 6, dans lequel les photodétecteurs (1401) et le ou les détecteurs pyroélectriques (1601) sont séparés par un diélectrique (6) ayant la propriété de réflecteur thermique et/ou d'isolant thermique.

8. Pixel selon l'une quelconque des revendications 1 à 7, dans lequel le ou les détecteurs pyroélectriques (1601) comportent une couche d'absorption infrarouge (168).

9. Pixel selon la revendication 8, dans lequel la couche d'absorption infrarouge (168) constitue une électrode (164, 166, 80) du ou des détecteurs pyroélectriques (1601).

10. Pixel selon la revendication 8 ou 9, dans lequel la couche d'absorption infrarouge (168) est en :
- dioxyde d'étain dopé en antimoine ;
- dioxyde d'étain ;
- Or ;
- PDOT:PSS ;
- nickel noir ;
- or noir ;
- chrome ; ou
- graphite.

11. Pixel selon l'une quelconque des revendications 1 à 10, dans lequel la première couche active (162) est en polyfluorure de vinylidène ou en l'un de ses copolymères, le copolymère étant de préférence choisi dans la liste :
- copolymère de fluorure de vinylidène et de trifluoroéthylène ;
- copolymère de fluorure de vinylidène et de chlorure de trifluoroéthylène ;
- copolymère de fluorure de vinylidène et de hexafluoropropylène ; et
- un mélange d'au moins deux de ces copolymères.

12. Pixel selon l'une quelconque des revendications 1 à 11, dans lequel la première couche active (162) est en polyfluorure de vinylidène ou en l'un de ses terpolymères, le terpolymère est de préférence du terpolymère de fluorure de vinylidène et de trifluoroéthylène et de chlorofluoroéthylene.

13. Pixel selon l'une quelconque des revendications 1 à 12, dans lequel la première couche active (162) est en :
- polyfluorure de vinyle ;
- polychlorure de vinyle ;
- titanate de baryum ;
- titano-zirconate de plomb ;
- tantalate de lithium ;
- sulfate de triglycine ;
- titanate de plomb ;
- fluorure de vinylidène trifluoroéthylène ; ou
- un mélange d'au moins deux de ces composés.

14. Pixel selon l'une quelconque des revendications 1 à 13 dans leur rattachement à l'une quelconque des revendications 8 à 10, dans lequel la couche d'absorption infrarouge (168) et la première couche active (162) sont mélangées au sein d'une même couche.

15. Pixel selon l'une quelconque des revendications 1 à 14 dans leur rattachement à l'une quelconque des revendications 8 à 10, dans lequel la couche d'absorption infrarouge (168) et la première couche active (162) sont distinctes.

16. Pixel selon l'une quelconque des revendications 1 à 15, dans lequel la deuxième couche active (142) est en un matériau organique.

17. Capteur d'images comprenant plusieurs pixels (1) selon l'une quelconque des revendications 1 à 16.
